# EUROPÄISCHE PATENTANMELDUNG

(11) **EP 1 973 176 A2**
(43) Veröffentlichungstag der Anmeldung: **24.09.2008**
(21) Anmeldenummer: 08101460.7
(22) Anmeldetag: 11.02.2008
(51) Int. Cl.: H01L 41/053, H01L 41/22

(54) **Verfahren und Vorrichtung zur Herstellung eines Piezoaktormoduls mit einem umhüllten Piezoaktor und ein Piezoaktormodul**

(30) Priorität: 19.03.2007 DE 102007012922; 05.09.2007 DE 102007042216
(71) Anmelder: ROBERT BOSCH GMBH, 70442 Stuttgart (DE)
(72) Erfinder: Herwig, Roland, 74354, Besigheim (DE); Cromme, Peter, 96050, Bamberg (DE); De Paoli, Albano, 75417, Muehlacker (DE); Schaich, Udo, 70378, Stuttgart (DE); Neumann, Nicole, 73635, Rudersberg (DE); Pohl, Gerd, 02906, Waldhufen Thiemendorf (DE); Yilmazer, Cetin, 96052, Bamberg (DE)

(57) **Zusammenfassung**

Es wird ein Verfahren und eine Vorrichtung zur Herstellung eines Piezoaktormoduls (1) mit einem Piezoaktor (40) vorgeschlagen, der zwischen einem metallischen Aktorkopf (42) und einem metallischen Aktorfuß (41) eingespannt und mit einer Umhüllung (20;43) versehen wird, die am Aktorkopf (42), am Aktorfuß (41) und/oder am Piezoaktor (40) befestigt wird. Die Befestigung der Umhüllung (20;43) wird durch ein äußeres Anlegen eines die Umhüllung (20;43) umschließenden Metallteils (21;44) und eine Befestigung durch Aufpressen des Metallteils (21;44) mittels eines elektromagnetischen Umformverfahrens vorgenommen.

## Beschreibung

### Stand der Technik

Die Erfindung betrifft ein Verfahren und eine Vorrichtung zur Herstellung eines Piezoaktormoduls mit einem eine Umhüllung aufweisenden Piezoaktor oder auch einer Reihe von Piezoaktoren, gemäß der Gattung der Ansprüche 1 und 4 und ein so hergestelltes Piezoaktormodul, das beispielsweise in einem Piezoinjektor zur zeitpunkt- und mengengenauen Dosierung von Kraftstoff in einem Verbrennungsmotor eingesetzt werden kann, gemäß Anspruch 5.

Ein solcher Piezoinjektor besteht im wesentlichen aus einem Haltekörper und dem im Haltekörper angeordneten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer Spannung an die Piezoelemente eine Düsenöffnung freigegeben wird.

Diese Common Rail Injektoren können dabei so aufgebaut werden, dass eine indirekt vom Piezoaktor gesteuerte Düsennadel vorhanden ist, wobei der Piezoaktor direkt oder indirekt vom Druck des Kraftstoffs umgeben ist und zwischen der Düsennadel und dem Piezoaktor lediglich ein hydraulischer Kopplungsraum vorgesehen ist. Wenn die Piezoaktoren sich dabei im Niederdruckbereich des Kraftstoffs (ca. 60 bar) befinden, wie es bei indirekt gesteuerten Nadelbewegungen der Fall ist, so kann hier durchaus eine Metallhülsenabdichtung des Piezoaktors mit einer Membran als hub- und/oder temperaturausgleichendes Element realisiert werden.

In Diesel-Piezoinjektoren werden bei der so genannten direkten Düsennadelsteuerung die Piezoaktoren direkt im Dieselkraftstoff unter Hochdruck (ca. 2000 bar) betrieben, wobei die zuvor erwähnte relativ starre Hülsen-/Membranabdichtung den hohen Systemdrücken und den höheren Hubbewegungen des Piezoaktors unter den zur Verfügung stehenden Platzverhältnissen nicht standhalten würde.

Zum Schutz der Piezoelemente des Piezoaktors, beispielsweise auch im Hinblick auf deren elektrische Isolation, ist es daher auch bekannt, den Piezoaktor mit einem Elastomer zu umhüllen. Da die Anwesenheit von Kraftstoff, insbesondere hinsichtlich seiner leitfähigen Bestandteile, auf der Oberfläche des Piezoaktors zu einem elektrischen Überschlag zwischen den Elektroden und somit dem Versagen des Piezoaktors führen würde, muss der Piezoaktor vor dem direkten Kontakt mit dem Kraftstoff auch durch entsprechende Dichtheit an den Naht- oder Verbindungsstellen geschützt werden.

Aus der DE 101 39 871 A1 ist ein Piezoinjektor mit einem über einen hydraulischen Druckübersetzer auf ein Ventilglied einwirkenden Aktormodul bekannt, bei dem die Piezoelemente des Piezoaktors in einer mit einem metallischen Wellbalg versehenen Umhüllung angeordnet sind.

Aus der WO 2001 48834 A2 ist bekannt, dass die elektrische Isolation eines Piezoaktors mittels eines Schutzmantels aus Kunststoff vorgesehen wird, der beispielsweise durch Spritzgießen aufgebracht wird. Weiterhin ist bisher ist auch die Ummantelung des Aktormoduls mit einem stabilen an dem Aktorkopf und dem Aktorfuß angeschweißten Metallgehäuse mit Membran und Silikonfüllung bekannt.

### Offenbarung der Erfindung

Die Erfindung geht von einem eingangs beschriebenen Piezoaktormodul mit einem Piezoaktor aus, der zwischen einem metallischen Aktorkopf und einem metallischen Aktorfuß eingespannt und mit einer Umhüllung versehen wird, die am Aktorkopf, am Aktorfuß und/oder am Piezoaktor befestigt wird. Gemäß eines erfindungsgemäßen Verfahrens wird in vorteilhafter Weise die dichtende Befestigung der Umhüllung durch ein äußeres Anlegen eines die Umhüllung umschließenden Metallteils und eine Befestigung durch Aufpressen des Metallteils an der Umhüllung mittels eines elektromagnetischen Umformverfahrens vorgenommen.

Das elektromagnetische Umformverfahren ist für sich gesehen beispielsweise aus der DE 20 2004 014 6582 U1 bekannt, in der beschrieben ist, wie das elektromagnetische Umformen bei elektrisch und/oder magnetisch leitenden Werkstücken derat vorgenommen werden kann, dass eine Materialverformung in einer für den jeweiligen Anwendungsfall erforderlichen Form und Richtung durchgeführt werden kann.

Erfindungsgemäß kann das Verfahren bei der Herstellung eines Piezoaktormoduls vorteilhaft angewandt werden, bei dem der Piezoaktor Bestandteil eines Piezoinjektors für ein Einspritzsystem für Kraftstoff bei einem Verbrennungsmotor ist und der Kraftstoff die Umhüllung umströmt. Das Piezoaktormodul, die Umhüllung und die Metallteile können dabei eine runde, ovale, viereckige oder vieleckige Kontur aufweisen. Das Piezoaktormodul ist dabei beispielsweise im Hochdruckbereich des Kraftstoffs von mindestens 2000 bar pulsierend mit einer Temperaturbelastung im Bereich von ca. -40 bis +180°C eingesetzt und kann mit der Erfindung vor Feuchtigkeit (H₂O) Diesel, RME oder sonstigen elektrisch leitenden Substanzen und auch vor Partikeln, Schwebstoffen dauerhaft geschützt werden.

Die Umhüllungen des Piezoaktors können dabei flexible Kunststoff- oder Metallhülsen sein, welche zum Beispiel aufgeschrumpft oder auf andere Art und Weise der Kontur des Piezoaktors bzw. auch des Aktorkopfs und des Aktorfußes angepasst werden. Die Metallteile als Fügepartner können dabei unterschiedliche Formen aufweisen, mit denen sie ein dichtes Verschließen der Umhüllung gewährleisten, indem sie über die Umhüllung des Piezoaktors an die Kontur des Aktorkopfs und/oder des Aktorfußes anpressbar sind und dabei beispielsweise in Senken des anderen Fügepartners direkt oder indirekt eingreifen. Beispielsweise können die Metallteile zur Bildung eines mechanischen Anschlags über die Umhüllung herausragen oder die Metallteile weisen zur Bildung eines mechanischen Anschlags über die Umhüllung herausragend eine Schneidkante auf bzw. es können auch die Umhüllung, der Aktorkopf und/oder der Aktorfuß eine Schneidkante aufweisen, in die herausragende Metallteile einpressbar sind.

Das Verfahren wird so ausgeführt, dass eine pulsierende hohe Energie, beispielsweise im Bereich von ca. 5 bis 25 kJ, je nach verwendetem Werkstoff, und mit einer Pulsfrequenz im Bereich von ca. 6kHz im Bereich des Metallteils als einem Fügepartner und/oder der Umhüllung, des Aktorfußes, des Aktorkopfes und/oder des Piezoaktors als anderem Fügepartner durch eine Spule erzeugt wird. Der notwendige pulsierende hohe Strom in der Spule wird auf einfache Weise mittels eines Pulsgenerators erzeugt, der aus einer Kapazität und einem in Reihe geschalteten Hochstromschalter besteht und damit die Spule in der Nähe der Fügepartner derart beaufschlagt, dass eine Materialbewegung und/oder Verformung bei mindestens einem der Fügepartner erfolgt.

Es werden ferner noch Ausführungsformen vorgeschlagen, bei denen die durch das elektromagnetische Umformverfahren aufform- bzw. aufpressbaren Metallteile mit Beißkanten versehen sind, die an der Umhüllung des Piezoaktors und/oder am Aktorfuß und/oder am Aktorkopf anliegen, wobei die Metallteile seitlich direkt neben der Umhüllung oder mit einem seitlichen Abstand anliegen können.

Hierbei können durch die entsprechende Ausgestaltung der erfindungsgemäß als Ringe ausgeführten Metallteile bzw. Metallringe mögliche Durchmesserzordnungsveränderungen ausgeglichen werden. Zum Beispiel, wenn der Aktorfuß oder der Aktorkopf kleiner ist als der Schutzverbund mit der Umhüllung oder wenn diese nahezu gleichgroß sind oder wenn der Aktorfuß oder der Aktorkopf größer ist als der Schutzverbund mit der Umhüllung. Auch sind eine Vielzahl von speziellen konstruktiven Eingriffe an den Anbindeteilen (Aktorfuß, Aktorkopf) möglich, wie beispielweise Abschrägungen, um eine dementsprechende Formgebung des eventuell auch durchaus schon vorgeformten Magnetumformbaren Metallteils zu erreichen. In Richtung der Umhüllung kann das Metallteil jeweils kleiner werden, größer werden oder es kann beides miteinander kombiniert werden.

Die Erfindung kann dabei, wie schon erwähnt, sowohl mit einer festen Position der Metallteile relativ zu den Anbindeteilen (Aktorfuß, Aktorkopf), oder auf beiden Seiten eine durch die fertigungsbedingte Länge der Umhüllung bedingte freie Positionen innerhalb eines Abstandes aufweisen.

Weiterhin können zwischen den durch ein elektromagnetisches Umformverfahren aufformbaren Metallteilen und dem Aktorfuß und/oder dem Aktorkopf auch zusätzliche Metallringe liegen und die Metallteile können am Auflagebereich auf der Umhüllung auch unterschiedliche Konturen als Wölbungen, Riffelungen, Wellen, Rillen oder Widerhaken aufweisen.

Die vorgeschlagene erfindungsgemäße Anbindung der Umhüllung bzw. des Schutzverbunds an die Anbindeteilen (Aktorfuß, Aktorkopf) ist insbesondere dann vorteilhaft, wenn ein Längenausgleich der Fertigungstoleranzen bei Bewahrung der Anbindungsdichtheit vorrangig bei Metall als Umhüllung erreicht werden soll.

### Kurze Beschreibung der Zeichnungen

Die Erfindung wird nachfolgend anhand der in den Zeichnungen gezeigten Ausführungsbeispiele erläutert. Dabei zeigen:
- Figur 1: eine schematische Darstellung eines Piezoinjektors mit einem Piezoaktormodul nach dem Stand der Technik im Längsschnitt,
- Figur 2: eine Darstellung von unterschiedlichen Konturen eines Piezoaktormoduls,
- Figur 3a bis 3e: mögliche Ausführungsbeispiele von durch elektromagnetische Umformung erpressbaren Metallteilen,
- Figur 4: eine schematische Darstellung einer Vorrichtung zur elektromagnetischen Umformung von Fügepartnern,
- Figur 5: ein Ausführungsbeispiel von Fügepartnern mit einer Expansionsspule,
- Figur 6: ein Ausführungsbeispiel von Fügepartnern mit einer Kompressionsspule,
- Figur 7: ein Ausführungsbeispiel von Fügepartnern mit einer Flachspule,
- Figur 8: ein Ausführungsbeispiel mit einem durch Magnetumformung angeformten oder angeschrumpften Metallteil bzw. Metallring mit Beißkanten auf dem oder den Anbindeteilen,
- Figur 9: ein Ausführungsbeispiel mit einem durch Magnetumformung angeformten oder angeschrumpften Metallteilen mit Beißkanten auf dem oder den Anbindeteilen und auf der Umhüllung des Piezoaktors,
- Figur 10 und 11: jeweils ein Ausführungsbeispiel mit einem durch Magnetumformung angeformten oder angeschrumpften Metallteil mit Beißkanten auf dem oder den Anbindeteilen, die einen seitlichen Abstand zur Umhüllung aufweisen oder direkt anliegen,
- Figur 12 und 13: jeweils ein Ausführungsbeispiel mit einem durch Magnetumformung angeformten oder angeschrumpften Metallteil mit Beißkanten auf der Umhüllung und jeweils zusätzlichen Metallringen, auf denen die durch Magnetumformung angeformten oder angeschrumpften Metallteile aufliegen und
- Figuren 14a bis 14f: jeweils Ausführungsbeispiele der Metallteile mit Beißkanten und unterschiedlichen Konturen des Auflagebereichs der Metallteile auf der Umhüllung des Piezoaktors.

### Ausführungsformen der Erfindung

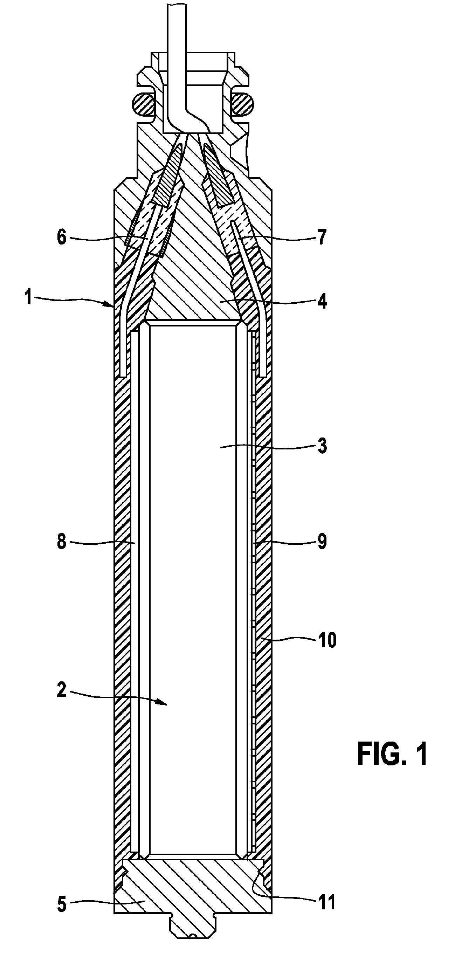

In Figur 1 ist ein Piezoaktormodul 1 mit mindestens einem Piezoaktor 2 gezeigt, das beispielsweise zur Nadelhubsteuerung im Einspritzsystem für Kraftstoff bei einem Verbrennungsmotor eingesetzt werden kann. Piezoelemente 3 sind Bestandteil des Piezoaktors 2, der weiterhin noch einen Aktorfuß 4 und einen Aktorkopf 5, beispielsweise aus Stahl aufweist. Es sind elektrische Zuleitungen 6 und 7 durch den Aktorfuß 4 geführt, die über Außenelektroden 8 und 9 an hier nicht dargestellten Innenelektroden im Piezoelement 3 kontaktiert sind. Bei einer Betätigung des Piezoaktors 2 durch eine Spannungsbeaufschlagung der Innenelektroden kann eine hier senkrecht unterhalb des Aktorkopfes 5 befindliche mechanische Anordnung derart betätigt werden, dass hier eine Freigabe einer Düsenöffnung des Einspritzsystems erfolgen kann.

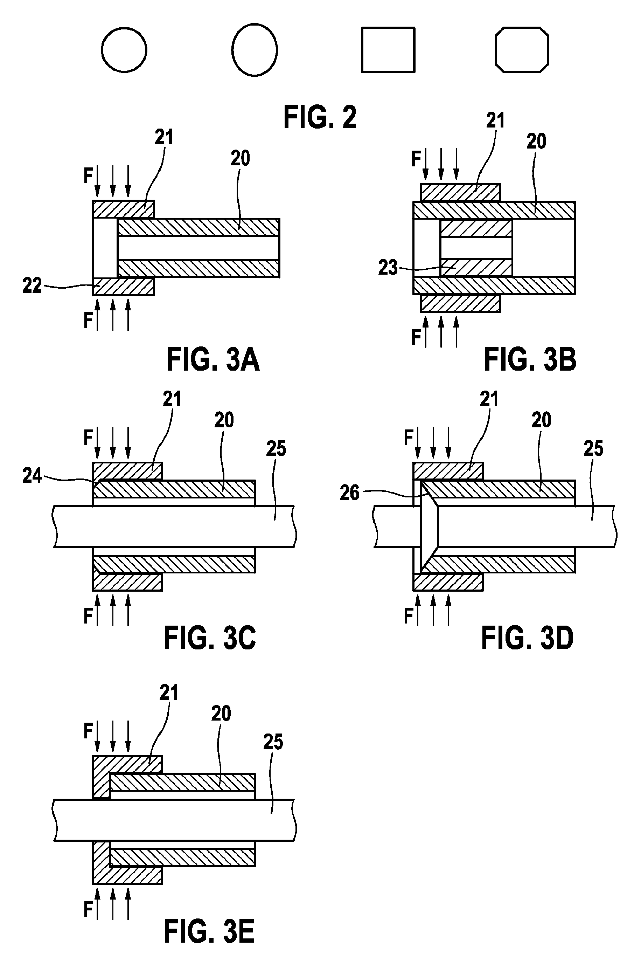

Das Piezoaktormodul 1 mit dem Piezoaktor 2 ist gemäß Figur 2 rund, oval, viereckig oder vieleckig ausgeführt und in einem hier nicht gezeigten Injektorkörper eingebaut, wobei der Kraftstoff durch den Innenraum des Injektorkörpers an der Anordnung 1 vorbeigeführt wird. Dieser Kraftstoff kann dann beispielsweise bei einem sogenannten Common Rail System unter dem in der Beschreibungseinleitung erwähnten Raildruck oder einem anderen vorgebbaren Druck in den Brennraum eines hier nicht dargestellten Verbrennungsmotors injiziert werden.

Um den Piezoaktor 2 vor dem umströmenden Kraftstoff und vor sonstigen schädlichen Einwirkungen zu schützen, ist eine Umhüllung 10 vorhanden, die insbesondere die empfindlichen Piezoelemente 3 fest umschließt und außerdem mit dem Aktorkopf 5 über eine Verkrallung oder Verpressung 11 bei der Montage verbunden ist.

Gemäß der Erfindung sind in Figur 3a bis 3e verschiedene Metallteile gezeigt, die mit dem weiter unten erläuterten Verfahren der elektromagnetischen Umformung gemäß der Kräftepfeile F auf eine erfindungsgemäße Umhüllung 20 oder Beschichtung und damit auf den Aktorkopf 5 oder Aktorfuß 4 (vgl. Figur 1) gepresst werden sollen. In der Figur 3a ist ein Metallteil 21 gezeigt, dass mit einem Teil 22 über die Umhüllung 20 hinausragt; in der Figur 3b ist ein Ausführungsbeispiel gezeigt, bei dem ein Vitonring 23 zwischen die Umhüllung und den hier nicht dargestellten Piezoaktor gefügt ist. Aus der Figur 3c ist erkennbar, dass das Metallteil 21 eine Schneidkante 24 aufweist und dass bei der Ausführung gemäß Figur 3d die Umhüllung 20 und ein Aktorkopf oder Aktorfuß 25 ebenfalls eine Schneidkante 26 aufweisen, über die ebenfalls ein Anschlag für den festen Sitz des Metallteils 21 erreichbar ist. Bei der Ausführung nach Figur 3e umschließt das Metallteil 21' die Umhüllung 20 axial und radial.

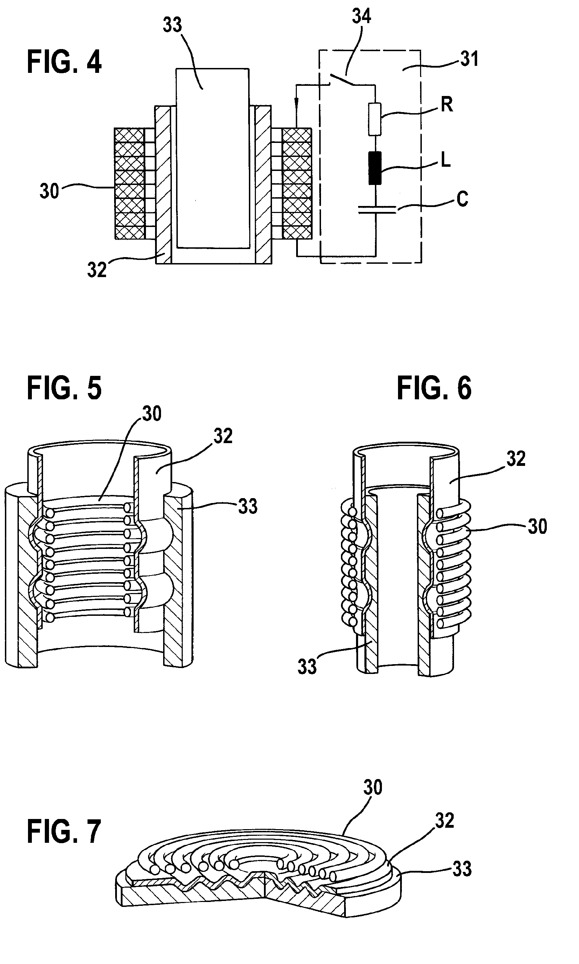

In Figur 4 ist schematisch gezeigt, wie mit einer Spule 30 das an sich aus dem Stand der Technik bekannte Verfahren erfindungsgemäß so ausgeführt wird, dass ein pulsierender hoher Strom von einem Pulsgenerator 31 erzeugt und in die Spule 30 geführt wird und dass die Spule 30 im Bereich des Metallteils 32 als einem Fügepartner und/oder im Bereich eines anderen Fügepartners 33 angeordnet ist. Der pulsierende hohe Strom wird auf einfache Weise mittels des Pulsgenerators 31 derart erzeugt, dass nach einem Startsignal mit einem Hochstromschalter 34 die Kapazität C diesen Strom über die innere Induktivität L, den inneren Widerstand R und die Spule 30 fließen lässt. Hierdurch erfährt das Metallteil 32 eine radiale Beschleunigung, mit der das Metallteil 32 auf den Fügepartner 33 gepresst wird.

Nach einem Umformprozess wird die Kapazität in kleinen Zeitabständen (zum Beispiel 75 - 150 s) wieder aufgeladen und der Prozess wiederholt sich. Um den elektromagnetischen Einfluss auf den Piezoaktor zu vermeiden, können hierbei auch Schutzbleche vorgesehen werden.

Aus Figur 5 ist ein Ausführungsbeispiel mit den Fügepartnern 32 und 33 zu entnehmen, bei dem die Spule 30 durch die Anwendung im Inneren der Anordnung als Expansionsspule fungiert und in Figur 6 ist ein Ausführungsbeispiel von Fügepartnern 32 und 33 gezeigt, bei dem die Spule 30 außen als Kompressionsspule wirkt. Nach Figur 7 ist auch möglich, dass die Fügepartner 32 und 33 Scheiben sind und die Spule 30 somit als darüberliegende Flachspule ausgeführt ist.

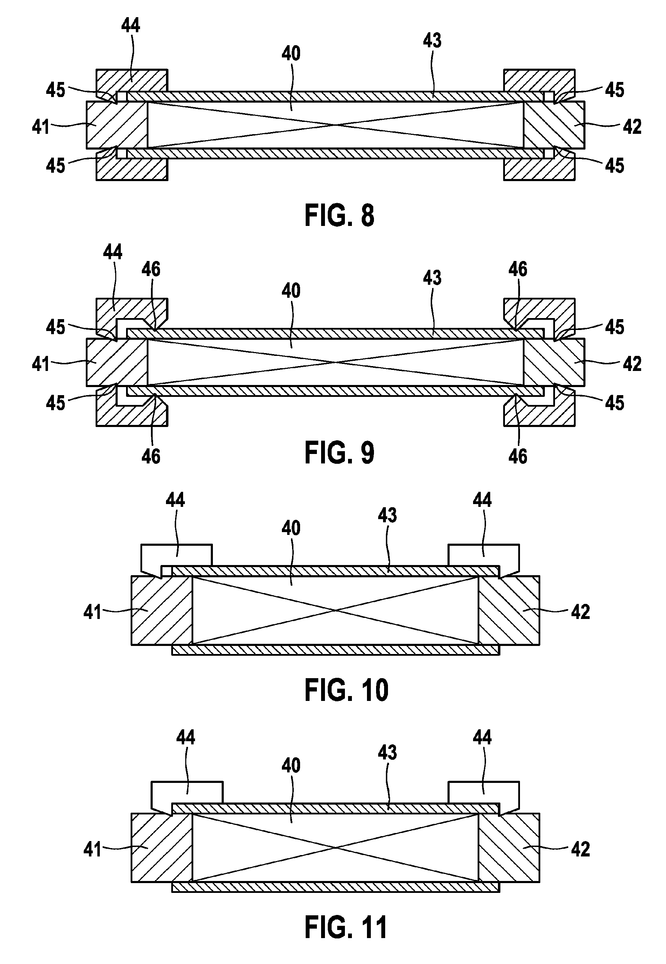

Figur 8 zeigt ein Ausführungsbeispiel eines Piezoaktors 40 oder einer Reihe von solchen aneinander geschalteten Piezoaktoren mit einem Aktorfuß 41 und einem Aktorkopf 42 als Anbindeteile. Um den Piezoaktor 40 ist eine Umhüllung 43 als Schutzverbund gelegt, der im wesentlichen aus einem elektrisch isolierendem Füllmaterial und einer äußeren mechanisch verstärkenden Hülle besteht. An diese Umhüllung 43 sind mittels einer zuvor beschriebenen elektromagnetischen Umformung Metallteile 44 als Ringe dicht angebracht, die über Beißkanten 45 verfügen, die fest an den Aktorfuß 41 und den Aktorkopf 42 angebracht sind.

Aus Figur 9 ist ein Ausführungsbeispiel zu entnehmen, bei dem in Abwandlung zu der Figur 8 die durch die Magnetumformung angeformten oder angeschrumpften Metallteile 44 zusätzlich auch mit Beißkanten 46 versehen sind, die auf die Umhüllung 43 einwirken.

In Figur 10 und Figur 11 sind jeweils Ausführungsbeispiele gezeigt, bei denen die durch Magnetumformung angeformten oder angeschrumpften Metallteile 44 einseitig mit einem Abstand in Längsrichtung (Figur 10 links) und auf der anderen Seite direkt anliegen (Figur 10 rechts) bzw. an beiden direkt anliegen (Figur 11).

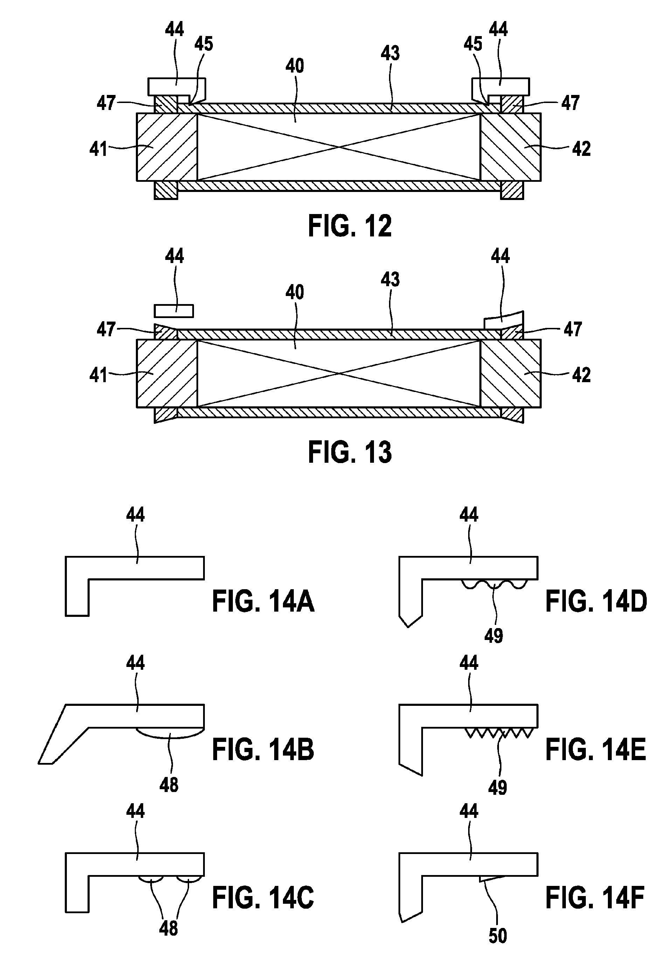

Figur 12 und 13 zeigen jeweils ein Ausführungsbeispiel mit durch Magnetumformung angeformten oder angeschrumpften Metallringen 44, die über einen zusätzlichen Metallring 47 verfügen, auf dem die mit den Beißkanten 45 versehenen Metallteile 44 am Aktorfuß 41 und am Aktorkopf 42 aufliegen. Anhand der Figur 13 ist erkennbar, wie das Metallteil 41 jeweils vor dem Magnetumformen aussieht (linke Seite) und dann nach dem Magnetumformen auf dem zusätzlichen Metallring 47 aufliegt (rechte Seite). Bei einem entsprechenden, hier nicht dargestellten Ausführungsbeispiel, können die zusätzlichen Metallringe auch ein fester konstruktiver Bestandteil des Aktorfußes 41 oder der Aktorkopfes 42 sein.

Aus den Figuren 14a bis 14f sind jeweils Varianten des Metallteils 44 im Schnitt zu entnehmen, die unterschiedliche Konturen des Auflagebereichs des Metallteils 44 auf der Umhüllung 43 des Piezoaktors 40 aufweisen. Die Figur 14a zeigt eine glatte Kontur, die Figur 14b zeigt eine Kontur mit einer Wölbung 48, die Figur 14c zeigt eine Kontur mit zwei Wölbungen 48, die Figuren 14d und 14e zeigen Konturen mit unterschiedlichen Riffelungen oder Rillen 49 und die Figur 14f zeigt eine Kontur mit einem Widerhaken 50.

## Patentansprüche

1. Verfahren zur Herstellung eines Piezoaktormoduls (1) mit einem oder mehreren Piezoaktoren (40), der/die zwischen einem metallischen Aktorkopf (42) und einem metallischen Aktorfuß (41) eingespannt und mit einer Umhüllung (20) versehen wird, die am Aktorkopf (42), am Aktorfuß (41) und/oder am Piezoaktor (40) befestigt wird, **dadurch gekennzeichnet, dass** die Befestigung der Umhüllung (20;43) durch ein äußeres Anlegen eines die Umhüllung (20;43) umschließenden Metallteils (21;44) und eine Befestigung durch Aufpressen des Metallteils (21;44) mittels eines elektromagnetischen Umformverfahrens vorgenommen wird.

2. Verfahren nach Anspruch 1, **dadurch gekennzeichnet, dass** das elektromagnetische Umformverfahren mittels einer pulsierenden hohen Energie durchgeführt wird, die im Bereich des Metallteils (21;44) als einem Fügepartner und/oder der Umhüllung (20;43), des Aktorfußes (41), des Aktorkopfes (42) und/oder des Piezoaktors (40) als anderem Fügepartner durch eine Spule (30) erzeugt wird.

3. Verfahren nach Anspruch 1 oder 2, **dadurch gekennzeichnet, dass** die Energie im Bereich von ca. 5 bis 25 kJ und die Pulsfrequenz im Bereich von ca. 6 kHz liegt.

4. Vorrichtung zur Durchführung des Verfahrens nach einem der vorhergehenden Ansprüche, **dadurch gekennzeichnet, dass** ein pulsierender hoher Strom in der Spule (30) mittels eines Pulsgenerators (31) erzeugt wird, der aus einer Kapazität (C) und einem in Reihe geschalteten Hochstromschalter (34) besteht und damit die Spule (30) in der Nähe der Fügepartner (21;32,33) derart beaufschlagt, dass eine Materialbewegung und/oder Verformung bei mindestens einem der Fügepartner (21;32,33) erfolgt.

5. Piezoaktormodul hergestellt nach einem der Ansprüche 1 bis 3 oder mit der Vorrichtung nach Anspruch 4, **dadurch gekennzeichnet, dass** das Metallteil (21;44) als Fügepartner über die Umhüllung (20;43) des Piezoaktors (40) an die Kontur des Aktorkopfs (25;42) und/oder des Aktorfußes (25;41) anpressbar ist.

6. Piezoaktormodul nach Anspruch 5, **dadurch gekennzeichnet, dass** die Metallteile (21;44) zur Bildung eines mechanischen Anschlags über die Umhüllung (20;44) herausragen.

7. Piezoaktormodul nach Anspruch 5, **dadurch gekennzeichnet, dass** zwischen der Umhüllung (20;43) und dem Aktorkopf (25;42) oder dem Aktorfuß (25;41) ein Vitonring (23) angeordnet ist.

8. Piezoaktormodul nach Anspruch 5, **dadurch gekennzeichnet, dass** die Metallteile (21) zur Bildung eines mechanischen Anschlags über die Umhüllung (20) herausragend eine Schneidkante (24) aufweisen.

9. Piezoaktormodul nach Anspruch 5, **dadurch gekennzeichnet, dass** die Umhüllung (20), der Aktorkopf (5;25) und/oder der Aktorfuß (4;25) eine Schneidkante (26) aufweisen, in die herausragende Metallteile (21) einpressbar sind.

10. Piezoaktormodul nach einem der Ansprüche 5 bis 9, **dadurch gekennzeichnet, dass** das Piezoaktormodul, die Umhüllung (20;43) und die Metallteile (21;44) eine runde, ovale, viereckige oder vieleckige Kontur aufweisen.

11. Piezoaktormodul nach einem der Ansprüche 5 bis 10, **dadurch gekennzeichnet, dass** die durch ein elektromagnetisches Umformverfahren aufformbare Metallteile(44) mit Beißkanten (45,46) an der Umhüllung (43) des Piezoaktors (40) und/oder am Aktorfuß (41) und/oder am Aktorkopf (42) versehen sind und dass die Metallteile (44) direkt der Umhüllung (43) oder mit einem seitlichen Abstand anliegen.

12. Piezoaktormodul nach Anspruch 11, **dadurch gekennzeichnet, dass** zwischen den durch ein elektromagnetisches Umformverfahren aufformbaren Metallteilen (44) dem Aktorfuß (41) und/oder dem Aktorkopf (42) zusätzliche Metallringe (47) liegen.

13. Piezoaktormodul nach Anspruch 12, **dadurch gekennzeichnet, dass** die Metallringe (47) Bestandteile des Aktorfußes (41) und/oder des Aktorkopfes (42) sind.

14. Piezoaktormodul nach Anspruch 11, 12 oder 13, **dadurch gekennzeichnet, dass** die Metallteile (44) am Auflagebereich auf der Umhüllung (43) unterschiedliche Konturen als Wölbungen (48), Riffelungen (49), Rillen,Wellen oder Widerhaken (50) aufweisen

15. Verwendung eines Piezoaktormoduls nach einem der vorhergehenden Ansprüche, **dadurch gekennzeichnet, dass** der Piezoaktor (2) Bestandteil eines Piezoinjektors für ein Einspritzsystem für Kraftstoff bei einem Verbrennungsmotor ist, wobei der Kraftstoff die Umhüllung (20;43) umströmt.
